Europäisches Patentamt

European Patent Office

Office européen des brevets

(19)

(11) Numéro de publication: **0 369 916**
**A1**

(12) # DEMANDE DE BREVET EUROPEEN

(21) Numéro de dépôt: **89460040.2**

(22) Date de dépôt: **10.11.89**

(51) Int. Cl.5: **H01R 9/26**

(30) Priorité: **18.11.88 FR 8815219**

(43) Date de publication de la demande:
**23.05.90 Bulletin 90/21**

(84) Etats contractants désignés:
**AT BE CH DE ES GB GR IT LI LU NL SE**

(71) Demandeur: **Société D. THERM SA**
**18, Avenue du Général Ferrié BP 11**
**F-35405 Saint Malo(FR)**

(72) Inventeur: **Deleage, Pierre Michel**
**Les Clos de Brons Saint Suliac**
**F-35430 Châteauneuf d'Ille et Vilaine(FR)**

(74) Mandataire: **Le Guen, Louis François**
**CABINET Louis LE GUEN 38, rue Levavasseur**
**B.P. 91**
**F-35802 Dinard Cédex(FR)**

(54) **Appareil modulaire de régulation de grandeurs physiques, en particulier de chauffage.**

(57) Appareil modulaire de régulation de grandeurs physiques, en particulier de chauffage. Il est formé de plusieurs modules (M1 à Mn) prévus pour être montés les uns à côté des autres sur un rail, avec, entre tous les modules voisins, un dispositif de raccordement (CX). Les dispositifs de raccordements sont constitués par des connecteurs mâles double face (Fd, Fg) prévus pour être enfichés dans des connecteurs femelles (Cd, Cg) portés latéralement par chaque module (Mi) de chaque côté du module. Les douilles femelles des deux connecteurs femelles (Cd, Cg) d'un module sont réunies deux à deux par des conducteurs (F1 à F20) imprimés sur une carte de circuit imprimé (p).

Les conducteurs (F1 à F20) de la carte imprimée (P) sont sélectivement connectables à des mailles internes (MA) du module par l'intermédiaire d'un ensemble de contacts repos/travail (18), également porté par ladite carte imprimée (P).

FIG.1

EP 0 369 916 A1

**Appareil modulaire de régulation de grandeurs physiques, en particulier de chauffage**

La présente invention concerne un appareil modulaire de régulation de grandeurs physiques et, en particulier, de régulation de chauffage.

D'une manière générale, un appareil de régulation de grandeurs physiques reçoit différentes informations de capteurs et d'organes de commande appropriés, traite ces informations en fonction d'un processus de traitement qui a été défini par l'utilisateur ou par le constructeur pour l'utilisateur, et délivre des signaux d'ordre à des transducteurs de manière à obtenir les valeurs désirées pour les grandeurs physiques. Dans un système de régulation de chauffage, les grandeurs physiques sont des intervalles de temps pendant lesquels un ou plusieurs générateurs de chauffage sont en fonctionnement; les capteurs sont des sondes de températures extérieures et intérieures, et des appareils de mesure d'intensités électriques; les organes de commande sont des interrupteurs manuels et des boutons de réglage de valeurs de consigne; les transducteurs sont des jeux de relais établissant un courant électrique ou l'interrompant, et le processus de traitement comporte un logiciel qui, en fonction de données horaires et journalières, d'une part, de données de priorité, d'autre part, transforme les informations d'entrée en signaux d'ordre.

Dans la pratique, les constructeurs d'appareils de régulation doivent faire face à des cahiers des charges très diversifiées. Par exemple, en régulation de chauffage, le nombre de pièces à chauffer peut varier beaucoup d'une installation à une autre, la destination de l'installation va du domaine proprement domestique au domaine de la collectivité, etc. Il en résulte que les constructeurs cherchent à fabriquer des appareils modulaires, chaque type de module ayant une fonction particulière et, dans un appareil, le nombre de modules d'un type pouvant être variable. A titre indicatif, il existe une norme nationale et une norme européenne qui concernent la forme et le pas des modules utilisables dans les appareils de régulation de chauffage et, dans la suite, même si l'on suppose que l'invention s'applique particulièrement à de tels modules, on comprendra qu'elle s'applique quelle que soit la forme des modules.

On rappelle que, suivant ces normes nationale et européenne, les modules se mettent en place sur un rail, les uns à côté des autres. Chaque module est relié à un ou plusieurs des modules de l'appareil par ce que l'on appelera un "câblage local". En dehors du module horloge délivrant les informations horaires et journalières et, éventuellement d'un module d'affichage, chaque module est relié soit à un capteur, soit à un appareil de mesure, soit à un relais, soit à plusieurs de ceux-ci, par ce que l'on appelera un "câblage externe". L'invention ne concerne pas le câblage externe, mais uniquement la simplification du câblage interne. La réalisation classique du câblage interne consistant à établir des liaisons par des fils individuels présentent un certain nombre d'inconvénients. Elle nécessite l'utilisation de nombreux points de contact établi par serrage manuel. Il en résulte des pertes ohmiques variables. Les liaisons, plus elles sont nombreuses, sont plus difficiles à établir et rendent les erreurs de branchement plus fréquentes. Chaque extension ou évolution de l'appareil modulaire de régulation entraînent des déconnexions et des connexions importantes, réduisant l'efficacité de la modularité de l'appareil.

Dans le brevet français FR-A-2 608 847, on a proposé un connecteur de liaison prévu pour surmonter les inconvénients mentionnés ci-dessus. Toutefois, ce connecteur de liaison est relativement compliqué et ne permet pas d'utiliser les connecteurs de cartes imprimées qui sont disponibles dans le commerce.

Dans le document DE-A-2 205 086, il est décrit un ensemble de commande formé de modules montés sur un rail avec des liaisons transversales formées de connecteurs femelles latéraux et de connecteurs mâles disposés entre lesdits connecteurs femelles. Cette assemblage nécessite le montage des modules dans un ordre précis avant l'accrochage sur le rail.

Un objet de l'invention consiste à prévoir un appareil modulaire de régulation dans lequel le câblage interne est extrêmement simplifié, tout en utilisant des composants du commerce et permettant des évolutions ou des extensions de l'appareil d'une extrême simplicité, en n'ayant qu'à réaliser que le câblage externe et sans avoir à tenir compte de l'ordre des modules dans l'appareil.

Suivant une caractéristique de l'invention, il est prévu un appareil formé de plusieurs modules prévus pour être montés les uns à côté des autres sur un rail, avec, entre tous les modules voisins, un dispositif de raccordement, lesquels sont constitués par des connecteurs mâles double face prévus pour être enfichés dans des connecteurs femelles portés latéralement par chaque module de chaque côté du module, les douilles femelles des deux connecteurs femelles d'un module étant réunies deux à deux par des conducteurs imprimés sur une carte de circuit imprimé.

Suivant une autre caractéristique, les conducteurs de la carte imprimée sont sélectivement connectables à des mailles internes du module par l'intermédiaire d'un ensemble de contacts repos/travail, également porté par ladite carte imprimée.

Suivant une autre caractéristique, ladite carte imprimée est une carte à deux faces, sur la première face étant imprimés lesdits conducteurs et, sur la seconde face étant imprimés les fils du circuit fonctionnel du module et portant des composants électroniques dudit circuit, la première face portant encore lesdits connecteurs femelles et ledit ensemble de contacts et éventuellement d'autres composants électroniques ou des organes de commande et de réglage dudit circuit.

Suivant une autre caractéristique, le module comprend une seconde carte portant les organes de puissance de relation avec l'extérieur et reliée par des fils à la première plaque.

Suivant une autre caractéristique, chaque module se compose d'un boîtier présentant une ouverture supérieure et une ouverture inférieure fermée par une contre-plaque ou équivalent, deux parois latérales opposées du boîtier étant planes et les deux autres parois latérales étant symétriques et presentant chacune, de haut en bas, deux épaulements, sous le premier épaulement venant se loger une carte de circuit imprimé double face, et la partie verticale se trouvant entre les deux épaulements étant prolongée vers le bas pour former une cloison dont le bord inférieur est au-dessus de la base du boîtier, la face supérieure de la carte imprimée portant des organes de commande et de réglage accessibles par l'ouverture supérieure, la seconde carte imprimée étant logée au-dessus de la contre-plaque.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels:

la Fig. 1 est une vue éclatée schématique d'un appareil modulaire suivant l'invention,

la Fig. 2 est un schéma électrique d'un appareil suivant l'invention,

la Fig. 3 est une vue en coupe verticale d'un module d'un appareil suivant l'invention, et

la Fig. 4 est une vue en élévation du module de la Fig. 3.

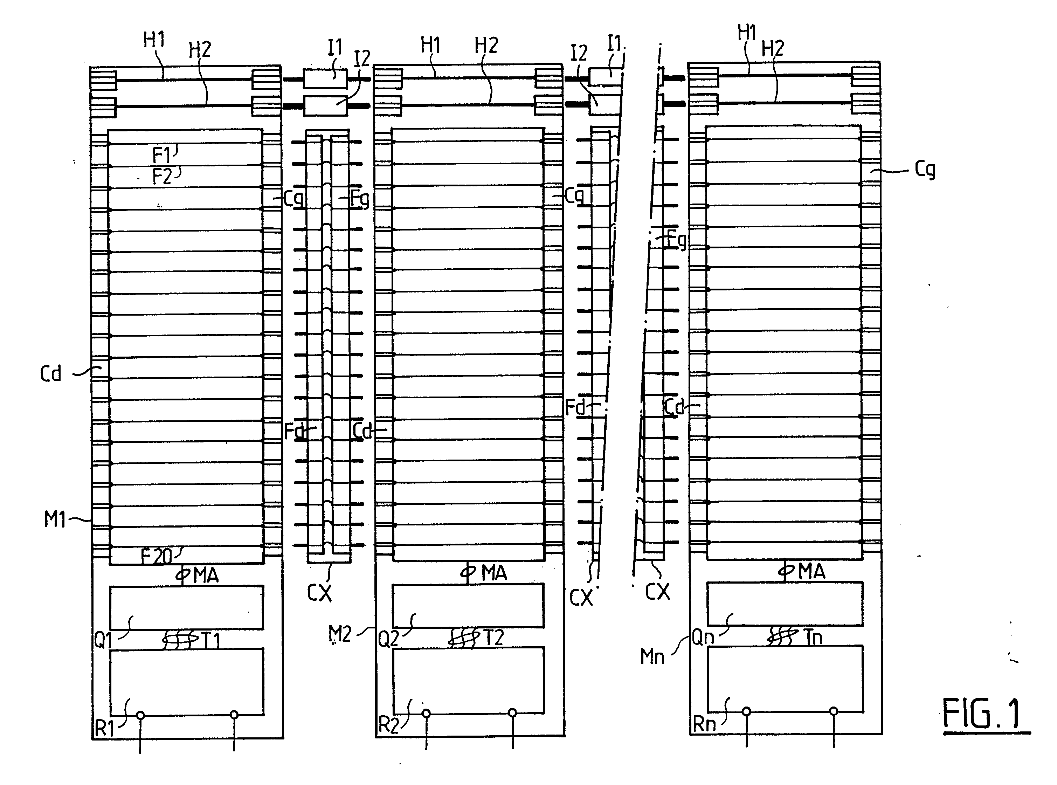

A la Fig. 1, on a montré un appareil formé de plusieurs modules M1, M2, ..., Mn, qui sont prévus pour être montés les uns à côté des autres sur un rail, avec, entre tous les modules voisins, un dispositif de raccordement CX. Dans la vue éclatée de la Fig. 1, les modules sont montrés alignés, mais déconnectés des dispositifs CX. Tous les coffrets des modules Mi ont une section verticale et une structure générale interne identiques, seules leurs largeurs peuvent varier par pas normalisé. Chaque module remplit une fonction de base spécifique, mais il y a généralement plusieurs modules qui remplissent individuellement la même fonction de base. A titre d'exemple, on va décrire la structure interne du module M1.

Le module M1 comprend une carte de circuits imprimés P, sur laquelle sont imprimés des conducteurs parallèles $F^1$ à $F^{20}$. A la carte P, sont associés deux connecteurs femelles Cd et Cg à vingt douilles chacun, qui sont respectivement reliées électriquement aux extrémités des conducteurs imprimés $F^1$ à $F^{20}$. Le connecteur Cd est accessible par la face latérale droite du module et le connecteur Cg par sa face latérale gauche.

Le module M1 comporte encore un circuit de traitement de signaux Q1 qui est relié par un faisceau de mailles MA à certains des conducteurs $F^1$ à $F^{20}$ et par des câbles T1 à un circuit d'interface R1 qui est lui-même relié à un ou plusieurs capteurs et/ou transducteurs externes, c'est-à-dire qui sont situés en dehors l'appareil proprement dit.

En pratique, le circuit Q1 est réalisé sur une carte de circuits imprimés classique qui peut être montée sous la forme d'une carte fille sur la carte mère P. Dans un autre exemple de réalisation, la carte P et la carte Q1 sont réalisées sous la forme d'une seule carte à circuits imprimés sur les deux faces, une face portant les conducteurs $F^1$ à $F^{20}$, plus les organes de réglage de consigne et d'autres circuits intégrés logiques, et l'autre face portant les conducteurs du circuit Q1 et les départs des câbles vers le circuit R1.

Le circuit R1 est également réalisé sous la forme d'une carte qui comporte des bornes plates de connexion vers les organes externes et porte éventuellement des composants électriques, tels que des relais ou des transformateurs ou autres composants. Le boîtier du module présentent des encoches pour le passage des fils de laiison vers les organes externes et des alvéoles dans lesquels des vis sont logés et permettent de raccorder les fils de liaison aux bornes du circuit R1. Dans la suite, l'appelation "borne" sera toujours utilisée pour désigner les points de liaison avec l'extérieur, qu'elles soient des bornes d'entrée ou de sortie.

Si la carte P est fonctionnellement identique dans tous les modules, les circuits Qi et Ri sont spécifiques à chaque module suivant sa fonction de base. En ce qui concerne les mailles MA, elles comportent chacune un contact, en série, qui peut être ouvert ou fermé, comme on le verra dans la suite.

Les dispositifs de raccordement CX sont chacun formés de deux connecteurs mâles Fd et Fg à vingt broches, physiquement montés dos à dos, les broches étant respectivement reliées deux à deux.

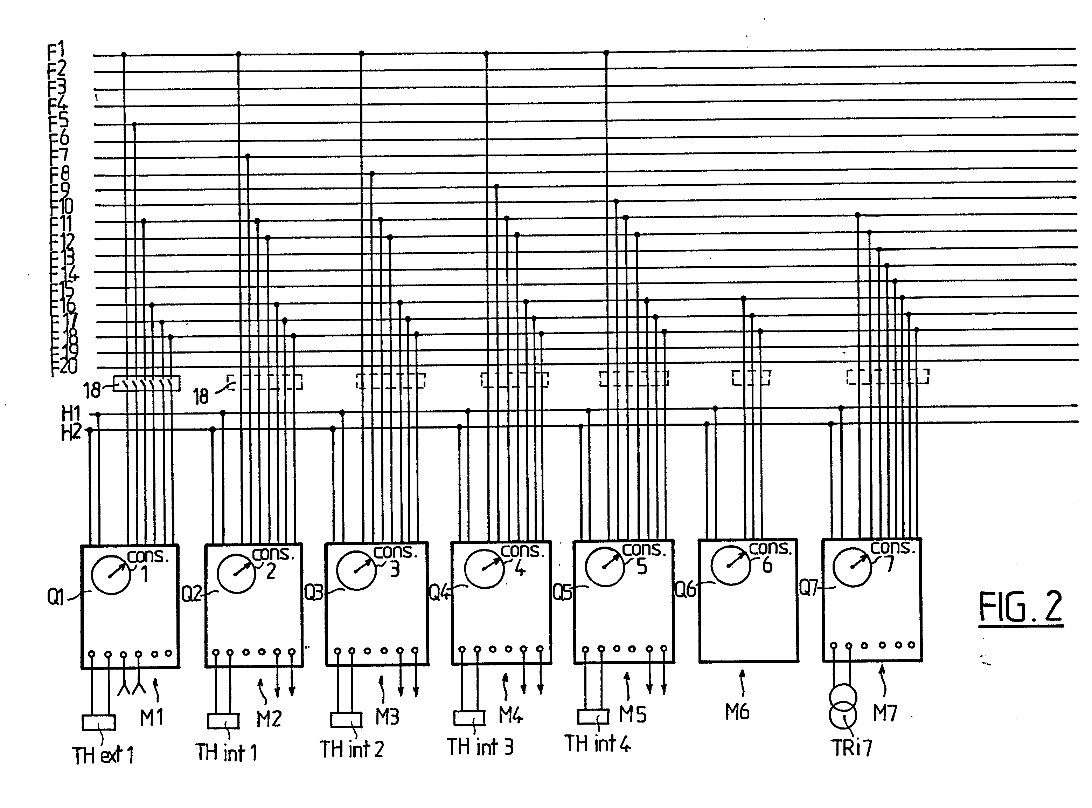

Une fois les dispositifs de connexion CX branchés dans les connecteurs femelles Cg et Cd des modules voisins, l'ensemble des conducteurs $F^1$ à $F^{20}$ forme un véritable bus à vingt fils parallèles, comme on l'a représenté à la Fig. 2. Dans ce bus, les différents fils $F^1$ à $F^{20}$ portent respectivement les signaux analogiques ou numériques suivants, étant entendu que ces signaux analogiques sont de faibles niveaux et que les signaux numériques sont surtout des signaux logiques:

| | | |
|---|---|---|
| F$^1$ | combinateur n° 1 | num. |
| F$^2$ | combinateur n° 2 | num. |
| F$^3$ | | libre |
| F$^4$ | potentiel de masse (O V) | anal. |
| F$^5$ | sonde extérieure n° 1 | anal. |
| F$^6$ | sonde intérieure n° 2 | anal. |
| F$^7$ | sonde intérieure n° 1 | anal. |
| F$^8$ | sonde intérieure n° 2 | anal. |
| F$^9$ | sonde intérieure n° 3 | anal. |
| F$^{10}$ | sonde intérieure n° 4 | anal. |
| F$^{11}$ | facteur de charge n° 1 | anal. |
| F$^{12}$ | facteur de charge n° 2 | anal. |
| F$^{13}$ | intensité n° 1 | anal. |
| F$^{14}$ | intensité n° 2 | anal. |
| F$^{15}$ | intensité n° 3 | anal. |
| F$^{16}$ | programme de délestage n° 1 | num. |
| F$^{17}$ | programme de délestage n° 2 | num. |
| F$^{18}$ | programme de délestage n° 3 | num. |
| F$^{19}$ | relais n° 1 | num. |
| F$^{20}$ | relais n° 2 | num. |

A la Fig. 1, on a encore montré dans chaque module, séparé de la carte P, deux conducteurs individuels H$^1$ et H$^2$ terminés, à chaque bout, par deux douilles femelles, et on a représenté, en face ces douilles, deux support I$^1$ et I$^2$ de broches mâles doubles. Les conducteurs H$^1$ et H$^2$, et les supports I$^1$ et I$^2$ servent à distribuer une alimentation électrique régulée, c'est-à-dire, comme on l'a montré à la Fig. 2, en H$^1$, une phase du secteur (220 V alt.) et, en H$^2$, le neutre du secteur.

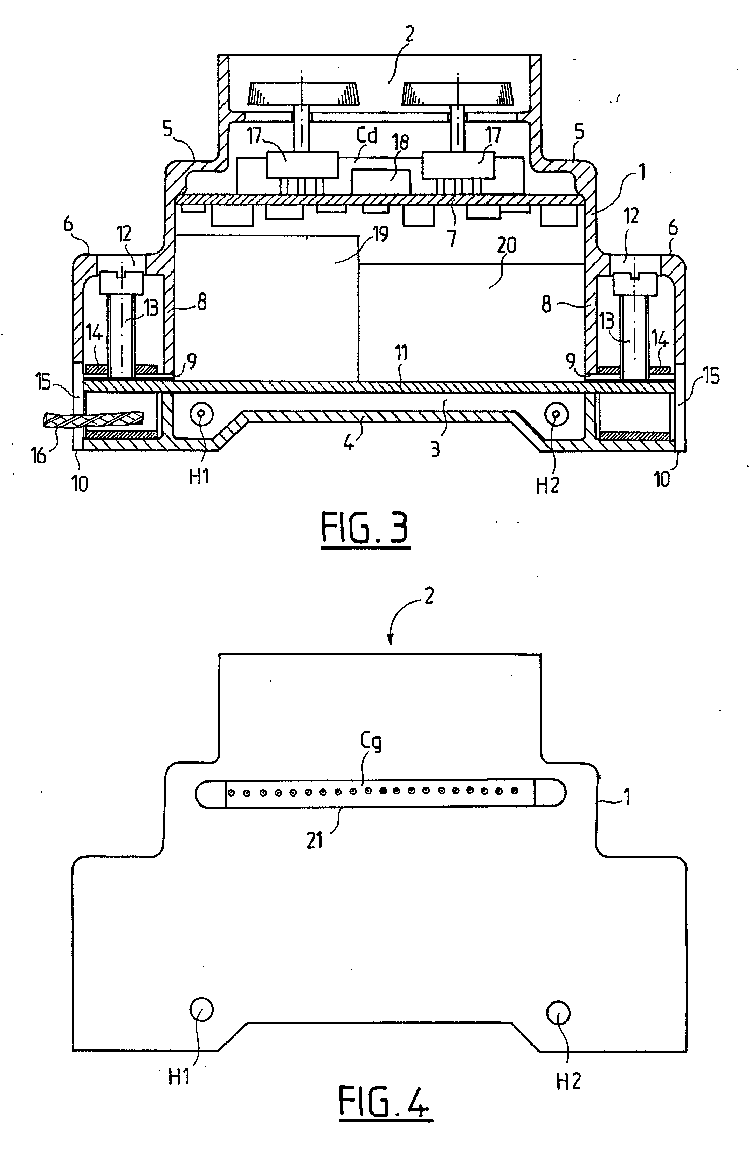

A la Fig. 2, on a omis les circuits de raccordement CX et les supports I$^1$ et I$^2$, et on a représenté, ininterrompus, les fils F$^1$ à F$^{20}$ et H$^1$ à H$^2$. Dans les modules schématiquement représentés M1 à M7, on n 'a représenté que les circuits de traitement correspondants Q1 à Q7 ainsi que leurs mailles MA les reliant au bus. Sur les mailles, on a également représenté les contacts des interrupteurs 18, Fig. 3. Pour chaque circuit de traitement, on a également représenté avec quels organes externes, il est en relation, mais sans montrer le circuit Ri correspondant.

Plus précisément, le module M1 est un module de régulation externe dont les bornes sont reliées à une sonde de température extérieure THext1. Pour des raisons d'ordre pratique, on a également choisi ce module comme moyen de connexion au secteur. Le circuit de traitement Q1 est muni d'un organe de réglage de consigne CONS1, d'un organe de réglage d'écart et d'un organe de réglage de base de temps. Le circuit de traitement Q1 reçoit la valeur de la température extérieure là où se trouve la sonde THext1 et traite cette valeur pour déterminer un premier facteur de charge ou facteur de charge n° 1, suivant la formule connue suivante:

facteur de charge n° 1 = (consigne - température ext. n° 1)/écart

Il comprend aussi une base de temps qui distribue des impulsions réglables entre deux limites, ces impulsions étant utilisées dans les modules thermostats.

Les mailles du circuit Q1 comprennent trois fils de sortie vers respectivement les conducteurs H$^1$ à H$^2$ pour distribuer une alimentation régulée aux autres modules, un fil vers le conducteur F$^{11}$ pour faire connaître le facteur de charge n° 1 aux autres modules qui ont à l'utiliser, et un fil vers le conducteur F$^1$ pour transmettre un signal logique à un module combinateur. A noter que tous les autres modules sont raccordés et alimentés par les conducteurs H$^1$ à H$^2$ et qu 'on ne mentionnera plus les liaisons correspondantes.

Dans le cas où dans l'installation à réguler on utilise une seconde sonde de température extérieure, l'appareil comprendra un autre module identique au module M1, mais non directement alimenté par le secteur et avec un fil de maille relié au conducteur F$^{12}$ au lieu du conducteur F$^{11}$, afin de faire connaître un facteur de charge n° 2. Le bloc d'interrupteurs 18, Fig. 3, permet facilement d'établir cette configuration.

Le module M2 est, à titre d'exemple, un module thermostat dont les bornes sont reliées à une sonde de température intérieure THint1 et à un relais CX1 qui commande l'alimentation d'un ou de plusieurs convecteurs électriques de chauffage, par exemple. Le circuit de traitement Q2 du module M2 est muni d'un organe de réglage de consigne CONS2. Ses mailles sont reliées aux conducteurs $F^{11}$ pour recevoir la valeur du facteur de charge n° 1, $F^1$ pour recevoir la base de temps, $F^{16}$ pour recevoir les ordres de délestage et $F^7$ pour délivrer la valeur de la température intérieure mesurée par THint1.

En pratique, le circuit Q2 commande le relais CX1 en fonction des données analogiques ou numériques qu'il reçoit du bus par ses mailles MA et en fonction de la température mesurée par THint1. En particulier, le signal de délestage reçu peut inhiber la commande de fonctionnement du relais CX1.

Les modules M3 à M5 ont une structure identique à celle du module $M^2$, sauf que leurs circuits Q3 à Q5 sont respectivement reliés aux conducteurs $F^8$ à $F^{10}$, au lieu du conducteur $F^6$.

Le module M6 est, à titre d'exemple, un module de programmation sans utilisation de bornes vers l'extérieur. Son circuit Q6 comprend une horloge hebdomadaire programmable permettant, par exemple, des réglages par secteur de deux heures, et porte des organes, tels que des interrupteurs de marche forcée ou d'arrêt. Il comporte deux mailles respectivement reliées aux conducteurs $F^{16}$ et $F^{17}$ pour distribuer les données de programmes n° 1 et n° 2.

Le module M7 est un module de délestage dont les bornes sont reliées à un transformateur d'intensité TRi7. Le circuit de traitement Q7 utilise la valeur de l'intensité délivrée par le transformateur TRi7 pour commander des délestages en fonction d'un programme de délestage préétabli. Il comporte un organe de réglage de consigne d'intensité et un organe de réglage de base de temps. Ses mailles comprennent trois fils vers respectivement conducteurs $F^{16}$, $F^{17}$ et $F^{18}$ qui transmettent les ordres de délestage aux modules thermostats M2 à M5, trois fils vers les conducteurs $F^{13}$ à $F^{15}$, mais seul le contact vers le conducteur $F^{13}$ est fermé, et deux fils vers les conducteurs $F^{11}$ et $F^{12}$.

On peut avoir d'autres types de modules, par exemple un module d'affichage qui est capable d'afficher toutes les valeurs analogiques présentes sur le bus, ou encore un module de simulation qui est lui capable d'appliquer sélectivement des va leurs sur certains conducteurs du bus afin de tester l'appareil et les configurations des modules avant sa mise en service ou en cours de dépannage. Comme on l'a encore mentionné, on peut avoir un ou plusieurs modules combinateurs qui en fonction du mot parallèle à deux bits transmis par les fils $F^1$ et $F^2$ actionne sélectivement un relais parmi quatre, par exemple.

Un module Mi, montré en coupe à la Fig. 3, comporte un boîtier 1 présentant une ouverture supérieure 2 et une ouverture inférieure 3 qui est, en fonctionnement, fermée par une contre-plaque 4. Les parois latérales, qui sont perpendiculaires au plan du dessin, sont symétriques et présentent chacune, de haut en bas, deux épaulement 5 et 6. Sous les épaulements 5 vient se loger une carte de circuit imprimée double face 7. La partie verticale qui se trouve entre les épaulements 5 et 6, est également prolongée vers le bas pour former un cloison 8 dont le bord inférieur 9 est au-dessus de la base 10 du boîtier 1. Contre les bords 9 est appliquée une seconde carte 11 de circuits imprimés, laquelle est maintenue en place par la contre-plaque 4.

Les épaulements 6 sont percés de trous verticaux 12 par lesquels on peut actionner des têtes de vis 13. Le bout de chaque vis 13 est vissé dans un côté d'un étrier 14. Le côté supérieur de l'étrier 14, dans lequel la vis 13 est vissée, se trouve au-dessus de la carte 11 tandis que l'autre côté de 14 se trouve entre la carte 11 et la contre-plaque 4. Au-dessous de l'épaulement 6, la paroi externe du boîtier présente des encoches 15 qui permettent chacune de loger l'extrémité 16 d'un conducteur de câble externe entre le côté inférieur de l'étrier 14 et une surface métallisée correspondante de la face inférieure de la carte 11 pour réaliser une connexion vers un organe externe, capteur ou relais. Pour réaliser la connexion, il suffit de visser la vis 13 qui soulève l'étrier 14 pour venir coincer l'extrémité conductrice 16 contre la carte 11.

La carte 7 comporte sur sa face supérieure les conducteur $F^1$ à $F^{20}$, les connecteurs femelles Cd et Cg, celui-ci n'étant pas visible sur la coupe), plus un certain nombre de potentiomètres 17 qui peuvent être actionnés par l'ouverture 2, et un groupe d'interrupteurs miniaturisés 18. Il en résulte que le tracé réel des conducteurs $F^1$ à $F^{20}$ peut ne pas être rectiligne comme l'indiquent les Figs. 1 et 2. La face inférieure de la carte 7 porte le circuit imprimé Qi ainsi que les composants, condensateurs, résistances, de ce dernier. Les interrupteurs 18 permettent d'ouvrir ou de fermer des mailles MA du circuit Qi.

Sur la face supérieure de la carte 11, qui constitue le circuit Ri, Fig. 1, sont également montés des composants électriques, tels qu'un transformateur 19 et un relais 20. A la Fig. 3, on n a pas montré les liaisons Ti entre la carte 7 et la carte 11, celles-ci étant réalisées par des fils isolés individuels.

La vue en élévation de la Fig. 4 montre une face latérale du boîtier, qui est parallèle au plan du dessin, qui comporte une ouverture 21 par laquelle on apperçoit les entrées femelles du connecteur Cg.

## Revendications

1) Appareil modulaire de régulation de grandeurs physiques et, en particulier, de régulation de chauffage, formé de plusieurs modules (M1 à Mn) prévus pour être montés les uns à côté des autres sur un rail, avec, entre tous les modules voisins, un dispositif de raccordement (CX), caractérisé en ce que les dispositifs de raccordements sont constitués par des connecteurs mâles double face (Fd, Fg) prévus pour être enfichés dans des connecteurs femelles (Cd, Cg) portés latéralement par chaque module (Mi) de chaque côté du module, les douilles femelles des deux connecteurs femelles (Cd, Cg) d'un module étant réunies deux à deux par des conducteurs ($F^1$ à $F^{20}$) imprimés sur une carte de circuit imprimé (P).

2) Appareil suivant la revendication 1, caractérisé en ce que les conducteurs ($F^1$ à $F^{20}$) de la carte imprimée (P) sont sélectivement connectables à des mailles internes (MA) du module par l'intermédiaire d'un ensemble de contacts repos/travail (18), également porté par ladite carte imprimée (P).

3) Appareil suivant la revendication 2, caractérisé en ce que ladite carte imprimée (P) est une carte (7) à deux faces, sur la première face étant imprimés lesdits conducteurs et, sur la seconde face étant imprimés les fils du circuit fonctionnel (Qi) du module et portant des composants électroniques dudit circuit, la première face portant encore lesdits connecteurs femelles et ledit ensemble de contacts et éventuellement d'autres composants électroniques ou des organes de commande et de réglage dudit circuit.

4) Appareil suivant la revendication 3, caractérisé en ce que chaque module (Mi) comprend une seconde carte (Ri) portant les organes de puissance de relation avec l'extérieur et reliée par des fils (Ti) à la première plaque.

5) Appareil suivant la revendication 4, caractérisé en ce que chaque module (Mi) se compose d'un boîtier (1) présentant une ouverture supérieure (2) et une ouverture inférieure (3) fermée par une contre-plaque (4) ou équivalent, deux parois latérales opposées du boîtier étant planes et les deux autres parois latérales étant symétriques et présentant chacune, de haut en bas, deux épaulements (5, 6), sous le premier épaulement (5) venant se loger une carte de circuit imprimé double face (7), et la partie verticale se trouvant entre les deux épaulements (5, 6) étant prolongée vers le bas pour former une cloison (8) dont le bord inférieur (9) est au-dessus de la base (10) du boîtier (1), la face supérieure de la carte imprimée (7) portant des organes de commande et de réglage accssibles par l'ouverture supérieure, la seconde carte imprimée (11) étant logée au-dessus de la contre-plaque (4).

FIG.1

EP 0 369 916 A1

FIG. 2

EP 0 369 916 A1

FIG. 3

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | DE-C-3030070 (R.JAEGERSKUEPPER)<br>* colonne 8, lignes 24 - 57; figures 1-4 *<br>---- | 1-5 | H01R9/26 |
| A | GB-A-2014367 (J.B.LUMPERT)<br>* abrégé; figure *<br>---- | 1 | |
| A,D | DE-A-2205086 (B.DOERING)<br>* page 2, alinéa 7,8; figure A *<br>----- | 1 | |

**DOMAINES TECHNIQUES RECHERCHES (Int. Cl.5 )**

H01R

Le présent rapport a été établi pour toutes les revendications

| Lieu de la recherche | Date d'achèvement de la recherche | Examinateur |
|---|---|---|
| LA HAYE | 07 FEVRIER 1990 | CRIQUI J.J. |

EPO FORM 1503 03.82 (P0402)